# EUROPEAN PATENT APPLICATION

(11) **EP 4 447 098 A1**
(43) Date of publication of application: **16.10.2024**
(21) Application number: 22903118.2
(22) Date of filing: 09.11.2022
(51) Int. Cl.: H01L 21/68, G01P 3/64, B08B 1/02, G03F 7/20

(54) **POSITION FINDING APPARATUS FOR WAFER, POSITION FINDING METHOD, AND WAFER SPEED COUNTING METHOD**

(30) Priority: 06.12.2021 CN 202111472231
(71) Applicant: Hangzhou Sizone Electronic Technology Inc., Hangzhou Zhejiang 311300 (CN)
(72) Inventor: YIN, Qi, Linan Hangzho, Zhejiang 311300 (CN); CHEN, Yangyang, Hangzhou, Zhejiang 311300 (CN)
(74) Representative: Becker, Eberhard
(86) International application number: PCT/CN2022/130777
(87) International publication number: WO 2023/103695

(57) **Abstract**

Disclosed is a position finding apparatus for a wafer. The wafer is in a rotating state, and the outer edge of the wafer is provided with a notch part. The position finding apparatus at least comprises: a signal transmitting mechanism used for transmitting a signal to a direction where the wafer is located, the signal being able to pass through the notch part, and the signal being blocked by the wafer when passing through the wafer; and a signal receiving mechanism used for receiving the signal transmitted by the signal transmitting mechanism so as to determine whether the notch part passes through the signal transmitting path or determine the number of times that the notch part passes through the signal transmitting path. Further disclosed is a wafer position finding method. Further disclosed is a wafer rotating speed counting method. According to the present invention, wafer positioning is realized, the position of the notch part of the wafer can be determined, the wafer taking/placing reliability in the processes is improved, the space of a device is saved, and the wafer rotating speed measurement reliability is improved.

## Description

### Technical Field

The invention belongs to the field of fabrication of semiconductor integrated circuit chips, and particularly relates to a wafer alignment device and method and a wafer speed calculation method.

### Description of Related Art

Chemical mechanical planarization is one process of the integrated circuit technology, the requirement for which will become higher accordingly with the development of the technology. As a wet process for wafer processing, a large quantity of grinding fluid and different chemical agents will be used during chemical mechanical planarization, so wafers need to be cleaned and dried at the end of the process to remove particles adhered to the surfaces of the wafers before the wafers enter the next process.

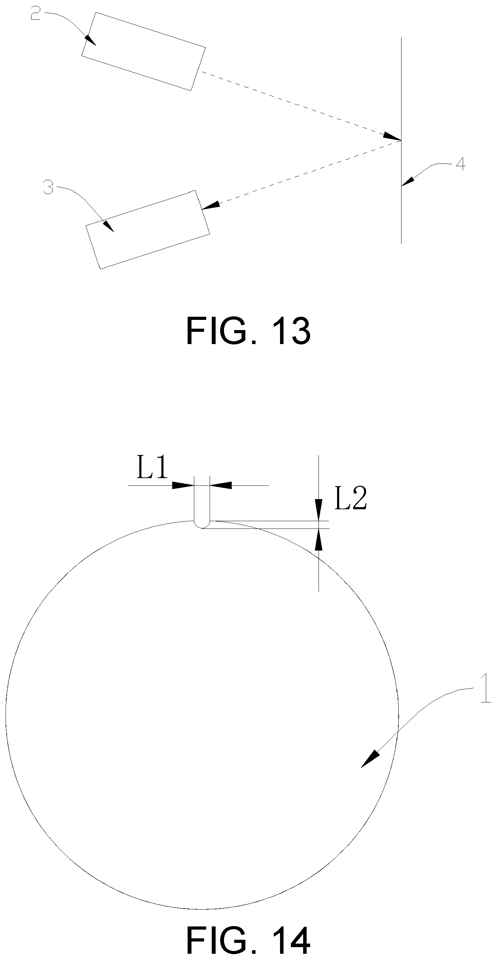

8-inch wafers and 12-inch wafers are positioned by means of a small notch with a width L1 of 1.5-3 mm and a depth L2 of 1-2 mm, as shown in FIG. 14, and a clamping mechanism can grip, transfer and position the wafers without being affected by the small notch, so it is unnecessary to align the notch. However, for 6-inch wafers, a notch for positioning is in the form of a flat which is as wide as 57.5 mm, that is, the overall size of the notch is large, so the wafers may fall when clamped by conventional tools, severely compromising the safety and reliability of the process. Therefore, the notch (flat) of the 6-inch wafers needs to be aligned and located to ensure that the wafers can be gripped without being affected by the notch.

If the notch for positioning wafers cannot be accurately located after cleaning, an extremely high positioning requirement will be raised to the clamping mechanism of a drying device, thereby increasing the complexity of the clamping mechanism and reducing the reliability of the clamping mechanism. In order to improve the wafer gripping, transferring and fixing reliability and accurately record the rotation speed of wafers, existing wafer alignment and speed calculation methods need to be improved.

### SUMMARY

To overcome the defects in the prior art, the invention provides a wafer alignment device which has a simple structure, a wafer alignment method which allows a notch of a wafer to face upward when the wafer stop rotating, and a wafer speed calculation method which can accurately calculate the rotation speed of a wafer.

The technical solution adopted by the invention is as follows: a wafer alignment device, wherein a wafer is in a rotating state, and an outer edge of the wafer is provided with a notch; the wafer alignment device at least comprises:
a signal transmitting mechanism used for transmitting a signal towards the wafer, wherein the signal is allowed to pass through the notch and will be blocked by the wafer other than the notch; and
a signal receiving mechanism used for receiving the signal transmitted by the signal transmitting mechanism to determine whether the notch passes through a signal transmission path or determine the number of times that the notch passes through the signal transmission path.

Further, the notch is horizontally cut in an edge of the wafer.

Further, when the signal completely passes through the notch, a vertical distance from the signal to a flat of the notch is h, and 0<h≤5mm.

Further, the signal transmitting mechanism and the signal receiving mechanism are located on a same side of the wafer; or, the signal transmitting mechanism and the signal receiving mechanism are located on two sides of the wafer; or, the signal transmitting mechanism and the signal receiving mechanism are configured as an integrated structure.

Further, the signal transmitting mechanism is a laser generator, the signal receiving mechanism is a laser receiver, and the signal is a laser band.

Further, the wafer alignment device further comprises a reflector, the signal transmitting mechanism is a transmissive laser generator, and the signal receiving mechanism is a transmissive laser receiver; or
the wafer alignment device further comprises a reflector, and the signal transmitting mechanism and the signal receiving mechanism are configured as a retro-reflective laser generator.

Further, transparent covers are arranged outside the signal transmitting mechanism and the signal receiving mechanism.

Further, the wafer alignment device further comprises a signal processing mechanism connected to the signal transmitting mechanism and the signal receiving mechanism.

The invention further discloses a wafer alignment method, comprising the following steps:
determining a signal intensity threshold when a signal transmitted by a signal transmitting mechanism completely passes through a notch;
starting the signal transmitting mechanism and a signal receiving mechanism, and driving a wafer to rotate by a driving mechanism;
slowing down the wafer for the first time, and allowing the wafer to rotate at a lower speed until a next signal at least partially enters the notch;
receiving the signal by the signal receiving mechanism, and slowing down the wafer for the second time;
transmitting, by a signal processing mechanism, a signal for stopping the wafer to the driving mechanism when an intensity of the signal received by the signal receiving mechanism increases to the maximum; and
stopping the wafer, wherein a flat of the notch faces upward at this moment.

Further, the wafer is driven by a support wheel driving mechanism of a brushing device to rotate. An existing wafer brushing device completely clean the surface of the wafer through the cooperation of a support wheel driving system and a rolling brushing system; however, the wafer cannot stop at a fixed position after being brushed, and the notch for positioning in the wafer cannot be accurately located; moreover, a support wheel system in a tank of the existing brushing device is formed by two driving wheels and an powerless idle wheel, and the wafer drives the idle wheel to rotate to obtain the rotation speed of the wafer during the brushing process. By adopting such a solution, the transmission accuracy will be affected by sliding friction between the wafer and the surface of the idle wheel, so the true rotation speed of the wafer cannot be accurately obtained. The wafer alignment method and the speed calculation method provided by the invention can solve these problems to improve the wafer gripping and transferring accuracy after cleaning and accurately recode the rotation speed of the wafer.

Further, the notch is horizontally cut in an edge of the wafer; and when the signal completely passes through the notch, a vertical distance from the signal to a flat of the notch is h, and 0<h≤5mm.

The invention further discloses a wafer speed calculation method, comprising the following steps:
starting a signal transmitting mechanism and a signal receiving mechanism, and driving a wafer to rotate by a driving mechanism;
when the signal passes through a notch, transmitting, by the signal receiving mechanism, the received signal to a signal processing mechanism, and recoding the time; and
when the signal passes through the notch again, reading a time interval by the signal processing mechanism, and obtaining a rotation speed of the wafer;
or, in a case where the signal passes through the notch multiple times, reading a total time interval by the signal processing mechanism, and obtaining a rotation speed of the wafer according to the total time interval and the number of times that the signal passes through the notch.

The invention has the following merits: wafer positioning is realized, the position of the notch in the wafer can be determined, the process control accuracy is high, positioning of notches of 6-inch wafers is realized, the wafer taking/placing reliability in the process is greatly improved, and the space of the device is saved; because the drying process has a high requirement for position control of the notch of the wafer, the position of the notch needs to be fixed before the wafer enters a drying unit, and after the wafer is brushed, the position of the notch of the wafer is determined and corrected directly by a brushing unit through the cooperation of the wafer alignment device and a support wheel driving mechanism, so clamping jaws can vertically lift the wafer directly without extra actions; the positioning function is integrated in the previous process to satisfy the requirement of the next process without disturbing the previous process and adding extra operations, the concept is novel, and space and time costs are reduced; the device and methods are suitable for 6-inch wafers, 8-inch wafers and 12-inch wafers; because the positioning signal will be unblocked only once every time the wafer rotates by 360°, one signal will be transmitted (a laser ranging sensor will detect a different distance signal), the wafer rotation speed measurement accuracy is higher than that of the idle wheel, and the wafer rotation speed detection reliability is improved.

### BRIEF DESCRIPTION OF THE DRAWINGS

FIG. 1 is a front view of a wafer according to the invention.
FIG. 2 is a perspective view of a brushing device according to the invention.
FIG. 3 is a front view of the brushing device according to the invention.
FIG. 4 is a sectional view along B-B in FIG. 3 in a case where no wafer is placed in the brushing device.
FIG. 5 is a sectional view along B-B in FIG. 3 in a case where the notch of a wafer placed in the brushing device does not face upward and a signal is blocked by the wafer.
FIG. 6 is a sectional view along B-B in FIG. 3 in a case where the notch of a wafer placed in the brushing device exactly faces upward.
FIG. 7 is a side view of the brushing device according to the invention.
FIG. 8 is a sectional view along C-C in FIG. 7.
FIG. 9 is an enlarged structural view of part A in FIG. 8.
FIG. 10 is a schematic diagram in a case where a wafer rotates to a position where a signal is partially blocked.
FIG. 11 is a schematic diagram of a signal transmitting mechanism and a signal receiving mechanism located on different sides according to the invention.
FIG. 12 is a schematic diagram of the signal transmitting mechanism and the signal receiving mechanism located on the same side according to the invention.
FIG. 13 is a schematic operating diagram in a case where the signal transmitting mechanism is a transmissive laser generator and the signal receiving mechanism is a transmissive laser receiver according to the invention.
FIG. 14 is a schematic diagram of a small notch of an existing 8-inch wafer.

### DESCRIPTION OF THE EMBODIMENTS

To allow those skilled in the art to gain a better understanding of the technical solutions of the invention, the technical solutions of the embodiments of the invention will be clearly and completely described below in conjunction with accompanying drawings of the embodiments. Obviously, the embodiments in the following description are merely illustrative ones, and are not all possible ones of the invention. All other embodiments obtained by those ordinarily skilled in the art based on the following ones without creative labor should also fall within the protection scope of the invention.

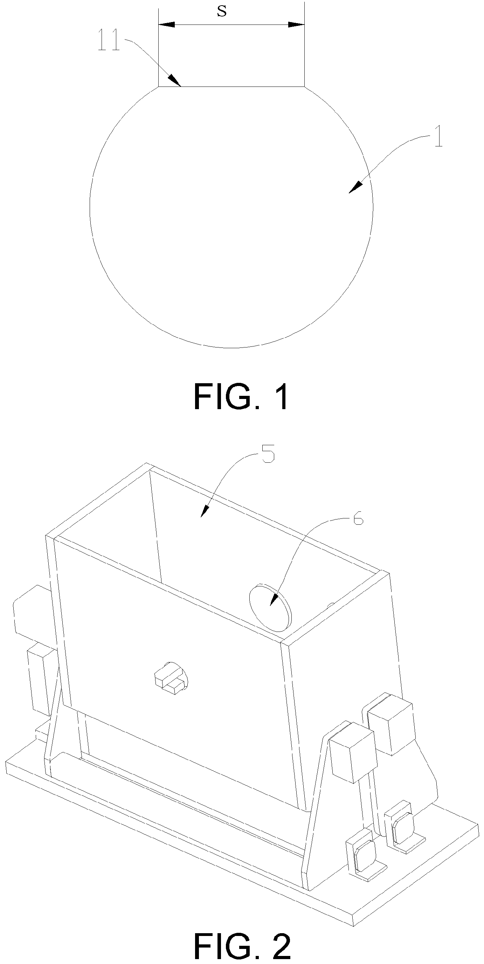

The invention provides a wafer alignment device. A wafer 1 is in a rotating state, an outer edge of the wafer 1 is provided with a notch 11, and the notch 11 is horizontally cut in the edge of the wafer 1, that is, the notch 11 has a flat. As shown in FIG. 1, the width s of the flat of the notch 11 reaches 57.5 mm.

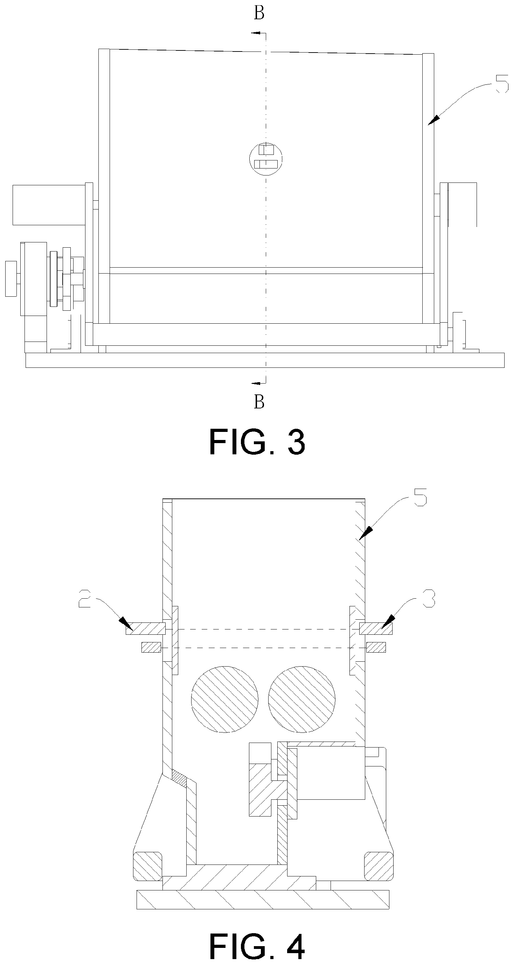

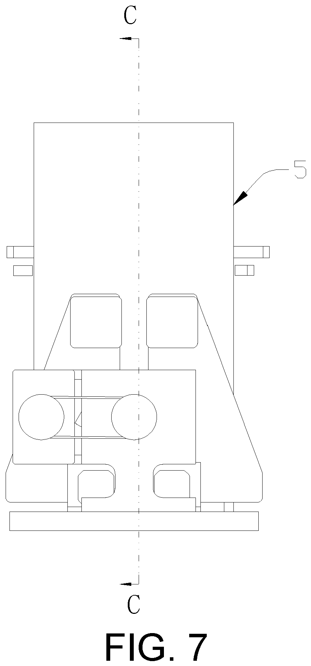

As shown in FIG. 3-FIG. 10, the wafer alignment device at least comprises a signal transmitting mechanism 2 and a signal receiving mechanism 3.

The signal transmitting mechanism 2 is used for transmitting a signal towards the wafer 1, and the signal can pass through the notch 11 and will be blocked by and cannot pass through the wafer 1 other than the notch 11.

The signal receiving mechanism 3 is used for receiving the signal transmitted by the signal transmitting mechanism 2 to determine whether the notch 11 passes through a signal transmission path or determine the number of times that the notch 11 passes through the signal transmission path. In other words, when the signal passes through the notch 11, the signal receiving mechanism 3 can receive the signal; when the signal is blocked by the wafer 1, the signal receiving mechanism 3 cannot receive the signal.

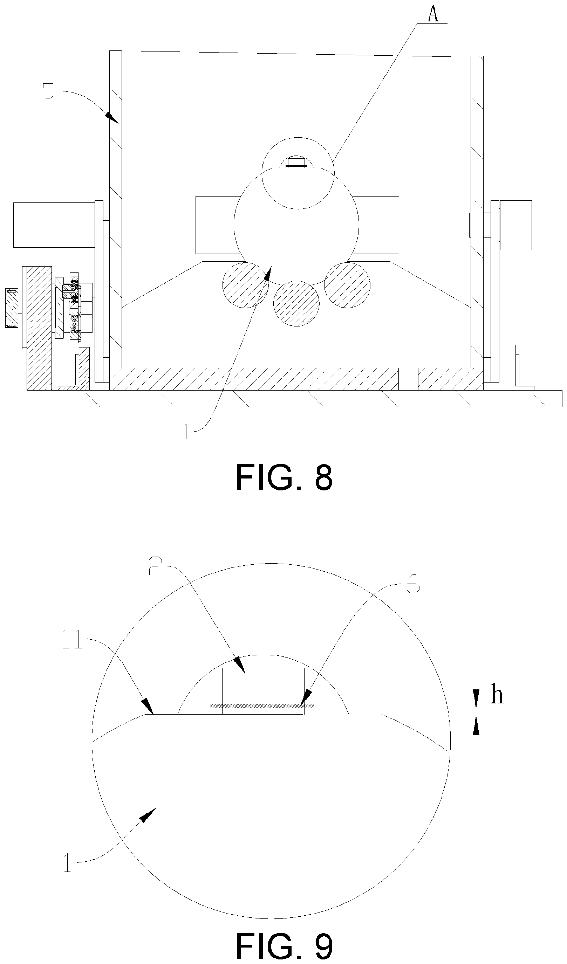

To ensure that the signal has a sufficient intensity after passing through the notch 11, a vertical distance from the signal to the flat of the notch 11 when the signal completely passes through the notch 11 is h which satisfies 0<h≤5mm, specifically as shown in FIG. 9.

When the notch 11 faces upward, the signal will be completely received by the signal receiving mechanism 3, and the intensity of the signal is high; after the wafer 1 rotates by a certain angle, the signal will be partially blocked, and the intensity of the signal will decrease. The position accuracy of the notch 11 of the wafer can be improved by adjusting a signal threshold of the signal receiving mechanism 3. That is, a higher intensity of the received signal indicates the signal is received to a larger extent, the levelness of the position of the notch 11 is higher and the notch 11 is more likely to face upward; and a lower intensity of the signal indicates that the levelness of the position of the notch 11 is lower. In actual application, the signal threshold of the signal receiving mechanism 3 can be adjusted according to the requirement for the levelness of the position of the process notch (the requirement for the position accuracy of the notch 11). In addition, the detection sensitivity can be adjusted by adjusting the distance from the signal receiving mechanism 3 to the notch 11 and the distance from the signal transmitting mechanism 2 to the notch 11, that is, the shorter the distances, the higher the detection sensitivity.

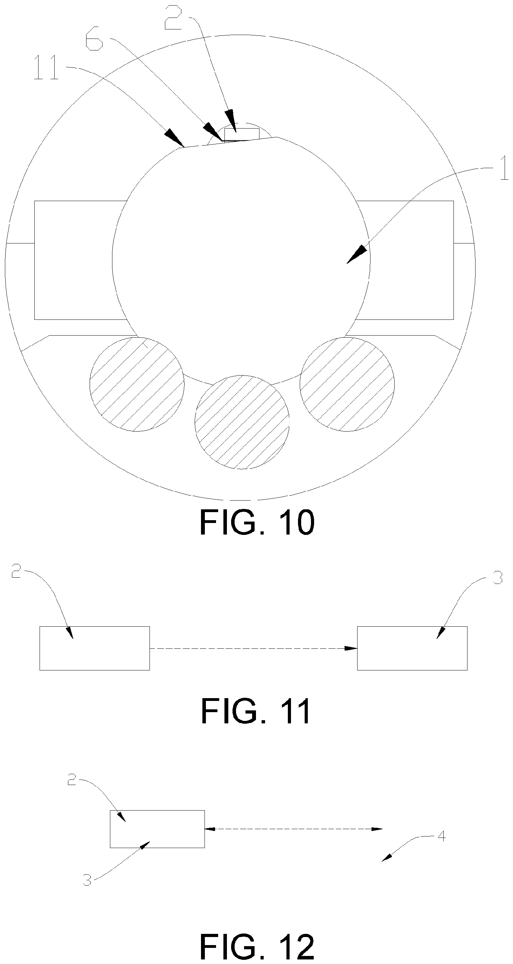

The signal transmitting mechanism 2 and the signal receiving mechanism 3 are located on two sides of the wafer 1, as shown in FIG. 11. In this case, the signal transmitting mechanism 2 is a laser generator, the signal receiving mechanism 3 is a laser receiver, the signal 6 is a laser band, and correspondingly, the wafer alignment device further comprises a signal processing mechanism. In other embodiments, the signal may be a laser point, and in this case, whether the signal passes through the notch 11 is determined according to the presence or absence of the laser point. Of course, the signal may also be in any other forms such as an optical signal or an ultrasonic signal, and the invention has no specific limitation in this aspect.

The signal transmitting mechanism 2 and the signal receiving mechanism 3 may be configured an integrated structure, as shown in FIG. 12. In this case, the signal transmitting mechanism 2 and the signal receiving mechanism 3 are configured as a retro-reflective laser generator, and correspondingly, the wafer alignment device further comprises a reflector 4 and a signal processing mechanism. The signal is transmitted from the retro-reflective laser generator and is then reflected by the reflector 4 back to the retro-reflective laser generator.

The signal transmitting mechanism 2 and the signal receiving mechanism 3 are located on the same side of the wafer 1, as shown in FIG. 13. In this case, the signal transmitting mechanism 2 is a transmissive laser generator, the signal receiving mechanism 3 is a transmissive laser receiver, the signal 6 is a laser band, and correspondingly, the wafer alignment device further comprises a reflector and a signal processing mechanism connected to the signal transmitting mechanism 2 and the signal receiving mechanism 3. The signal is transmitted from the transmissive laser generator and is then reflected by the reflector 4 to the transmissive laser receiver.

To protect against pollution caused by liquid during the brushing process and ensure that the signal can be transmitted and received without being affected by light, transparent covers 7 are arranged outside the signal transmitting mechanism 2 and the signal receiving mechanism 3, as shown in FIG. 2.

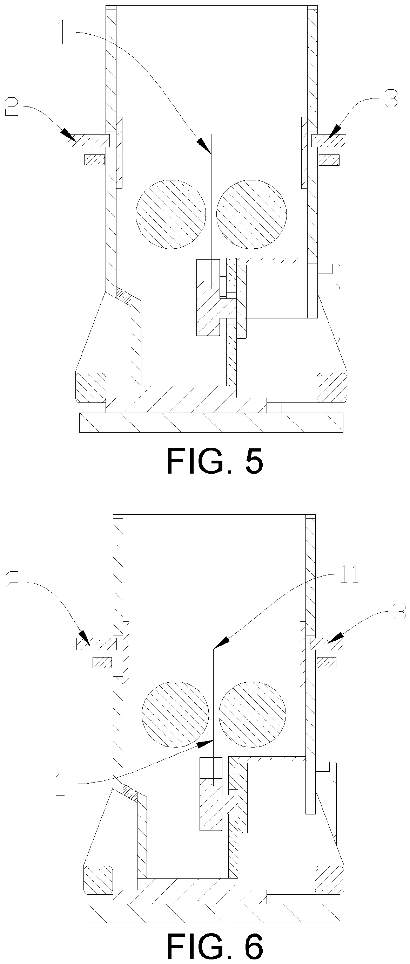

The signal transmitting mechanism 2 and the signal receiving mechanism 3 may also be arranged in an area corresponding to an incircle of the notch 11 of the wafer 1 or a concentric area of the wafer without the notch, and whether the wafer 1 is placed correctly is determined according to whether the signal receiving mechanism 3 receives the signal. If the laser signal is always blocked when the wafer 1 rotates around the center, the signal receiving mechanism 3 will not receive the signal, and it is determined that the wafer 1 is correctly placed, as shown in FIG. 6.

A wafer alignment method comprises the following steps.

A signal intensity threshold when a signal transmitted by a signal transmitting mechanism 2 completely passes through a notch 11 is determined, wherein when the signal completely passes through the notch 11, the signal is not blocked by the wafer 1 along the cross-section.

The signal transmitting mechanism 2 and a signal receiving mechanism 3 are started, and the wafer 1 is driven by a driving mechanism to rotate, wherein in this embodiment, the driving mechanism is a support wheel driving mechanism of a brushing mechanism 5; in other embodiments, the driving mechanism may be a support wheel driving mechanism of an ultrasonic cleaning device, or other driving mechanisms in a cleaning tank; the technique of driving the wafer 1 to rotate by the driving mechanism belongs to the prior art and will not be repeated here.

After the wafer 1 is brushed, the driving mechanism drives the wafer 1 to slow down for the first time, and then the wafer 1 continues to rotate at a lower speed until a next signal transmitted by the signal transmitting mechanism 2 at least partially enters the notch 11 (the signal starts to enter the notch 11).

The signal receiving mechanism 3 starts to receive the signal, the intensity of the signal increases gradually, at this moment, the wafer 1 slows down for the second time, and then the wafer 1 rotates at a constant speed or the rotation speed of the wafer 1 decreases gradually.

The intensity of the signal received by the signal receiving mechanism 3 increases gradually; when the intensity of the signal received by the signal receiving mechanism 3 becomes maximum (that is, the intensity of the signal received by the signal receiving mechanism 3 is equal to the signal intensity threshold which is determined previously), the signal completely passes through the notch 11, and a signal processing mechanism sends a signal to the driving mechanism to stop the wafer, wherein the signal previously transmitted between the signal transmitting mechanism 2 and the signal receiving mechanism 3 is also required by the signal processing mechanism, and all these functions can be realized by existing technology and will not be repeated here.

The wafer 1 stops rotating instantly, and a flat of the notch 11 exactly faces upward, that it, the flat of the notch 11 is parallel to the horizontal plane.

A wafer speed calculation method comprises the following steps.

A signal transmitting mechanism 2 and a signal receiving mechanism 3 are started, and a wafer 1 is driven by a driving mechanism to rotate.

When a signal passes through a notch 11, specifically, at the moment the signal completely passes through the notch 11, the signal receiving mechanism 3 transmits the received signal to a signal processing mechanism, and the time is recorded.

When the signal passes through the notch 11 again, specifically, at the moment the signal completely passes through the notch 11, the signal processing mechanism reads a time interval between the two times the signal passes through the notch 11, and the rotation speed of the wafer 1 is obtained.

Or, when the signal passes through the notch 11 again, specifically, at the moment the signal completely passes through the notch 11, the signal processing mechanism reads a time interval between the two times the signal passes through the notch 11; then, when the signal passes through the notch 11 again, the signal processing mechanism reads a time interval between the second time the signal passes through the notch 11 and the third time the signal passes through the notch 11; the operation is repeated; in a case where the signal passes through the notch 11 multiple times, the signal processing mechanism reads multiple time intervals, and the rotation speed of the wafer 1 is calculated according to an average time interval;

Or, in a case where the signal passes through the notch 11 multiple times, the signal processing mechanism reads a total time interval and the number of times that the signal passes through the notch 11, and then the rotation speed of the wafer 1 is obtained by calculation.

The above specific embodiments are used for explaining the invention rather than limiting the invention, and any modifications and variations made to the invention based on the spirit of the invention and within the protection scope of the claims should also fall within the protection scope of the invention.

## Claims

1. A wafer alignment device, **characterized in that**, a wafer (1) is in a rotating state, and an outer edge of the wafer (1) is provided with a notch (11); the wafer alignment device at least comprises:
a signal transmitting mechanism (2) used for transmitting a signal towards the wafer (1), wherein the signal is allowed to pass through the notch (11), and is blocked by the wafer (1) other than the notch (11); and
a signal receiving mechanism (3) used for receiving the signal transmitted by the signal transmitting mechanism (2) to determine whether the notch (11) passes through a signal transmission path or determine the number of times that the notch (11) passes through the signal transmission path.

2. The wafer alignment device according to claim 1, **characterized in that**, the notch (11) is horizontally cut in an edge of the wafer (1).

3. The wafer alignment device according to claim 2, **characterized in that**, when the signal completely passes through the notch (11), a vertical distance from the signal to a flat of the notch (11) is h, and 0 <h≤5mm.

4. The wafer alignment device according to claim 1, **characterized in that**, the signal transmitting mechanism (2) and the signal receiving mechanism (3) are located on a same side of the wafer (1); or, the signal transmitting mechanism (2) and the signal receiving mechanism (3) are located on two sides of the wafer (1); or, the signal transmitting mechanism (2) and the signal receiving mechanism (3) are configured as an integrated structure.

5. The wafer alignment device according to claim 4, **characterized in that**, the signal transmitting mechanism (2) is a laser generator, the signal receiving mechanism (3) is a laser receiver, and the signal is a laser band.

6. The wafer alignment device according to claim 4, **characterized in that**, the wafer alignment device further comprises a reflector (4), the signal transmitting mechanism (2) is a transmissive laser generator, and the signal receiving mechanism (3) is a transmissive laser receiver; or
the wafer alignment device further comprises a reflector (4), and the signal transmitting mechanism (2) and the signal receiving mechanism (3) are configured as a retro-reflective laser generator.

7. The wafer alignment device according to claim 1, **characterized in that**, transparent covers (7) are arranged outside the signal transmitting mechanism (2) and the signal receiving mechanism (3).

8. The wafer alignment device according to claim 1, **characterized in that**, further comprising a signal processing mechanism connected to the signal transmitting mechanism (2) and the signal receiving mechanism (3).

9. A wafer alignment method, **characterized in that**, comprising the following steps:
determining a signal intensity threshold when a signal transmitted by a signal transmitting mechanism completely passes through a notch;
starting the signal transmitting mechanism and a signal receiving mechanism, and driving a wafer to rotate by a driving mechanism;
slowing down the wafer for the first time, and allowing the wafer to rotate at a lower speed until a next signal at least partially enters the notch;
receiving the signal by the signal receiving mechanism, and slowing down the wafer for the second time;
transmitting, by a signal processing mechanism, a signal for stopping the wafer to the driving mechanism when an intensity of the signal received by the signal receiving mechanism increases to the maximum; and
stopping the wafer, wherein a flat of the notch faces upward at this moment.

10. The wafer alignment method according to claim 9, **characterized in that**, the wafer is driven by a support wheel driving mechanism of a brushing device to rotate.

11. The wafer alignment method according to claim 9, **characterized in that**, the notch is horizontally cut in an edge of the wafer; and when the signal completely passes through the notch, a vertical distance from the signal to the flat of the notch is h, and 0 < h≤5mm.

12. A wafer speed calculation method, **characterized in that**, comprising the following steps:
starting a signal transmitting mechanism and a signal receiving mechanism, and driving a wafer to rotate by a driving mechanism;
when the signal passes through a notch, transmitting, by the signal receiving mechanism, the received signal to a signal processing mechanism, and recoding the time; and
when the signal passes through the notch again, reading a time interval by the signal processing mechanism, and obtaining a rotation speed of the wafer;
or, in a case where the signal passes through the notch multiple times, reading a total time interval by the signal processing mechanism, and obtaining the rotation speed of the wafer according to a total time interval and the number of times that the signal passes through the notch.
